Europäisches Patentamt

European Patent Office

Office européen des brevets

(11) Numéro de publication : **0 449 721 B1**

## (12) FASCICULE DE BREVET EUROPEEN

(45) Date de publication du fascicule du brevet :
**21.06.95 Bulletin 95/25**

(21) Numéro de dépôt : **91400807.3**

(22) Date de dépôt : **26.03.91**

(51) Int. Cl.⁶ : **H03H 9/08**, H03L 1/04

(54) **Pilote thermostaté à résonateur piézoélectrique, peu sensible aux variations climatiques.**

(30) Priorité : **27.03.90 FR 9003880**

(43) Date de publication de la demande :
**02.10.91 Bulletin 91/40**

(45) Mention de la délivrance du brevet :
**21.06.95 Bulletin 95/25**

(84) Etats contractants désignés :
**CH DE FR GB LI**

(56) Documents cités :
**WO-A-89/12929**
**US-A- 1 901 735**
**US-A- 1 921 432**
**US-A- 4 354 133**
**PATENT ABSTRACTS OF JAPAN, vol. 10, no.**
**352 (E-458), 27 novembre 1986; & JP-A-61 152**
**112 (HITACHI) 10-07-1986**
**PATENT ABSTRACTS OF JAPAN, vol. 10, no.**
**24 (E-377)[2081], 30 janvier 1986; & JP-A-60 182**
**814 (KINSEKI) 18-09-1985**
**PATENT ABSTRACTS OF JAPAN, vol. 8, no. 74**
**(E-236)[1511], 6 avril 1984; & JP-A-58 222 610**
**(FUJITSU K.K.) 24-12-1983**

(73) Titulaire : **COMPAGNIE D'ELECTRONIQUE ET**
**DE PIEZO-ELECTRICITE - C.E.P.E.**
**44, avenue de la Glacière**
**F-95100 Argenteuil (FR)**

(72) Inventeur : **Thorax, Didier**
**THOMSON-CSF,**
**SCPI - CEDEX 67**
**F-92045 Paris La Defense (FR)**
Inventeur : **Seignol, Eric**
**THOMSON-CSF,**
**SCPI - CEDEX 67**
**F-92045 Paris La Defense (FR)**

(74) Mandataire : **Guérin, Michel et al**
**THOMSON-CSF**
**SCPI**
**B.P. 329**
**50, rue Jean-Pierre Timbaud**
**F-92402 Courbevoie Cédex (FR)**

## Description

La présente invention concerne un pilote thermostaté à résonateur piézoélectrique. Elle vise à améliorer la stabilité en fréquence du pilote lorsque les conditions climatiques varient.

Un pilote est un oscillateur piloté par un résonateur piézoélectrique. Le résonateur piézoélectrique peut être en quartz ou dans un autre matériau piézoélectrique, par exemple, en tantalate de lithium.

Un pilote thermostaté comporte principalement, à l'intérieur d'un boîtier de protection, une enceinte thermostatée, et un circuit imprimé pouvant comprendre notamment un circuit de régulation de tension, un amplificateur de sortie, un circuit de régulation de température. A l'intérieur de l'enceinte thermostatée on trouve, notamment un résonateur piézoélectrique associé à un circuit oscillateur monté sur un circuit imprimé.

Le résonateur piézoélectrique comprend dans un boîtier étanche, soumis au vide ou à une pression partielle d'azote, une lame d'un matériau piézoélectrique munie d'électrodes et maintenue entre deux poteaux conducteurs.

Le brevet US 1 921 431 décrit un résonateur piézoélectrique comportant un cristal piézoélectrique muni d'électrodes et encapsulé dans une enceinte thermostatée étanche.

Les performances en stabilité de fréquence, sur une large gamme de température, des pilotes actuels sont en évolution croissante.

Cela a permis de mettre en évidence l'influence de l'humidité, de la pression et de la température sur la stabilité en fréquence des pilotes.

La majorité des pilotes existants sont contenus dans un boîtier de protection métallique composé d'une embase et d'un capot. L'embase et le capot sont fixés ensemble lorsque le pilote a été testé mais la liaison reste souvent perméable à l'air. Le brevet WO 89/12 929 décrit une telle configuration. Le résonateur piézoélectrique encapsulé de manière étanche est placé dans une enceinte thermostatée elle-même placée dans le boîtier de protection. Dans d'autres pilotes, le boîtier de protection est fermé de façon étanche.

L'enceinte thermostatée comporte généralement un corps et un couvercle, le couvercle étant fixé par au moins deux vis dans le corps. L'enceinte est généralement réalisée dans un métal bon conducteur de la chaleur.

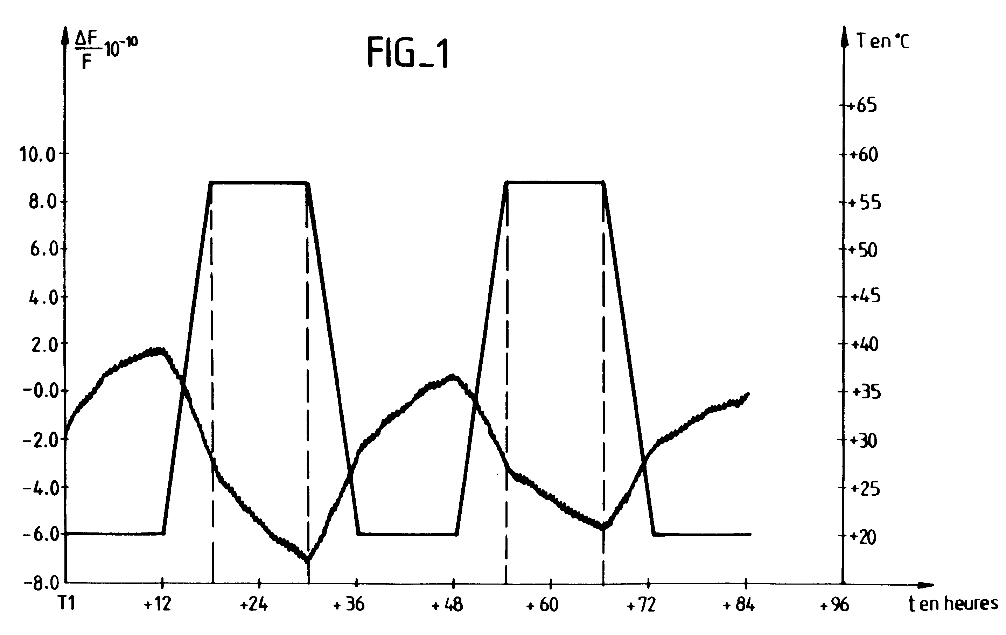

Lorsque l'on fait subir à un pilote thermostaté, contenu dans un boîtier de protection non étanche, des paliers de température alternativement chauds ou froids suffisamment longs, on s'aperçoit que la fréquence du pilote ne se stabilise pas. Pour illustrer ce phénomène, la figure 1 représente la variation relative de la fréquence d'un pilote thermostaté à quartz, en fonction du temps, lorsque la température extérieure varie par paliers. La courbe de température se décompose de la manière suivante :

- entre le temps T1 et T1+12 heures la température est constante et égale à +20° C;
- entre le temps T1+12 heures et T1+18 heures la température croit linéairement de +20° C à +57 ° C;
- entre le temps T1+18 heures et T1+30 heures la température est constante et égale à +57° C;
- entre le temps T1+30 heures et T1+36 heures la température décroît linéairement de +57 °C à +20°C. On répète ensuite, dans le même ordre les quatres étapes.

On s'aperçoit que la dérive en fréquence est négative pendant que la température croît et est positive pendant que la température décroît. C'est un phénomène qui est provoqué par les imperfections du thermostat, de l'enceinte et des composants électroniques montés à l'intérieur et à l'extérieur de l'enceinte. Ces imperfections sont connues et l'utilisation de composants performants permet de les réduire.

Mais, pendant les paliers, alors que la température est constante, la fréquence ne se stabilise pas. Pendant les paliers chauds la fréquence décroît et pendant les paliers froids, la fréquence croît.

Pendant les paliers de température, ce ne sont plus les variations de température extérieure qui agissent sur la fréquence.

De l'humidité est normalement présente à l'intérieur du boîtier de protection du pilote. Les variations de température que l'on a fait subir au pilote ont entraîné des répartitions différentes de l'humidité entre l'intérieur et l'extérieur de l'enceinte thermostatée.

Puisque le boîtier de protection du pilote n'est pas fermé de façon étanche, de l'humidité présente à l'extérieur du pilote a pu entrer dans le boîtier de protection. A l'inverse de l'humidité présente à l'intérieur du boîtier de protection a pu sortir vers l'extérieur.

Tous ces changements de taux d'humidité agissent directement sur les constantes diéléctriques des composants électroniques du pilote et notammment des composants placés à l'intérieur de l'enceinte thermostatée.

En conséquence, la fréquence du pilote varie.

Pour protéger les composants électroniques contre ces variations d'humidité, il est connu de les vernir. Cette solution ne présente pas de résultats réellement satisfaisants. Le vernis se dégrade dans le temps. Il a aussi une influence néfaste, que l'on ne peut négliger, sur les composants. On ne fait que limiter les transferts d'humidité.

On peut aussi fermer de façon étanche le boîtier de protection du pilote.

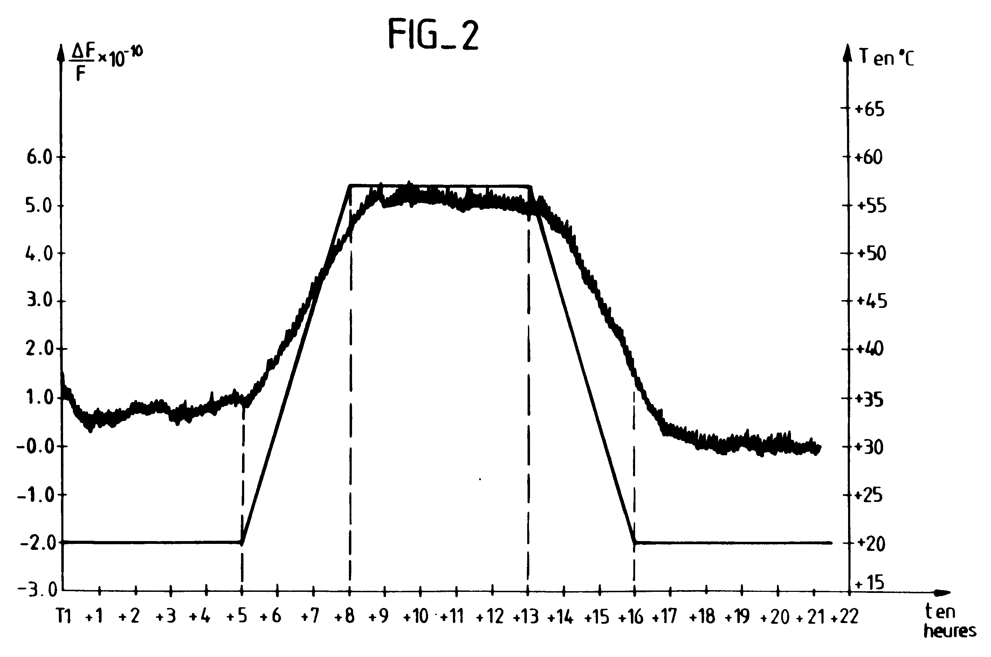

La courbe représentée sur la figure 2 montre la variation relative de la fréquence d'un pilote thermostaté à quartz, en fonction du temps, lorsque sa température extérieure varie par paliers. Maintenant le boîtier de protection du pilote est étanche.

La variation de la température est la suivante :

- entre le temps T1 et T1+5 heures, la température est constante et égale à +20° C;
- entre le temps T1+5 heures et T1+8 heures, la température croît linéairement de +20° C à +57° C;
- entre le temps T1+8 heures et T1+13 heures, la température est constante et égale à +57° C;
- entre le temps T1+13 heures et T1+16 heures, la température décroît linéairement de +57° C à +20° C;
- entre le temps T1+16 heures et T1+21 heures, la température est constante et égale à +20° C.

Dans cette configuration, on retrouve toujours un transfert d'humidité entre l'intérieur du boîtier de protection et l'intérieur de l'enceinte thermostatée.

Mais au lieu d'obtenir un résultat meilleur qu'avec la configuration précédente, on s'aperçoit que les variations relatives de la fréquence sont encore significatives. Elles ont été inversées et elles varient maintenant dans le même sens que la température.

En effet dans cette configuration, la variation de la température entraîne des écarts de pression à l'intérieur du boîtier de protection étanche selon la loi :

$$P.V = N.k.T$$

P est la pression dans le boîtier de protection, V est le volume du boîtier de protection, N et k sont des constantes, T est la température de l'intérieur du boîtier de protection.

L'enceinte thermostatée est fermée de façon perméable à la pression. Sa pression interne varie lorsque la pression dans le boîtier de protection varie. La variation de pression à l'intérieur de l'enceinte thermostatée agit sur le résonateur piézoélectrique. Il y a alors variation de l'écart entre les pressions internes et externes au résonateur. Cela se traduit souvent par une déformation des parois du boîtier du résonateur.

Le résonateur utilisé pour réaliser ces courbes est un résonateur en boîtier métallique ayant une sensibilité barométrique du $1.10^{-8}$/bar. C'est une sensibilité moyenne.

Pour améliorer les performances en fréquence du pilote, on peut, en gardant cette configuration, utiliser un résonateur beaucoup moins sensible aux variations de pression. De tels résonateurs sont souvent encapsulés dans des boîtiers en verre, ils sont plus encombrants et leur prix de revient est élevé.

Mais, même avec un résonateur peu sensible aux variations de pression, on n'obtient pas un pilote ayant une stabilité en fréquence recherchée. On est alors obligé de régler le pilote unitairement, en jouant sur les caractéristiques des composants électroniques utilisés. Ce réglage n'est pas compatible avec une industrialisation en série.

La présente invention vise à remédier à ces inconvénients en proposant un pilote thermostaté à résonateur piézoélectrique, ayant une dérive en fréquence réduite en fonction des variations d'humidité, de pression et de température.

L'invention permet d'obtenir un pilote performant tout en utilisant un résonateur piézoélectrique courant ayant une sensibilité barométrique moyenne. Le prix de revient du pilote est alors abaissé.

Le principe de l'invention consiste à maintenir à l'intérieur de l'enceinte thermostatée un taux d'humidité et une pression aussi constants que possible, lorsque les conditions climatiques varient à l'extérieur du boîtier de protection du pilote.

Pour cela on rend étanche l'enceinte thermostatée et l'on prévoit que le corps et le couvercle de l'enceinte thermostatée seront suffisamment rigides pour ne pas se déformer sous l'action de variations de pression externe à l'enceinte.

La présente invention propose un pilote thermostaté comportant un résonateur piézoélectrique inséré dans une enceinte thermostatée comprenant un corps et un couvercle, le résonateur comprenant un boîtier étanche caractérisé en ce qu'en vue de réduire la dérive en fréquence du pilote en fonction des variations climatiques, l'enceinte thermostatée est étanche et en ce que le corps et le couvercle de l'enceinte sont suffisament rigides pour supporter sensiblement sans déformation les différences de pression pouvant exister entre l'intérieur et l'extérieur de l'enceinte thermostatée.

Pour rendre étanche l'enceinte thermostatée on peut mettre soit de la pâte à joint, soit un joint entre le couvercle et le corps de l'enceinte. Des vis par exemple, maintiendront mécaniquement le couvercle sur le corps.

Selon une autre variante on peut coller le couvercle sur le corps de l'enceinte ou même le braser.

D'autres caractéristiques et avantages de l'invention ressortiront à la lecture de la description suivante illustrée par les figures annexées qui représentent :

- la figure 1, déjà décrite, la variation relative de la fréquence d'un pilote thermostaté classique, contenu dans un boîtier de protection perméable, en fonction du temps, lorsque la température extérieure au pilote varie;
- la figure 2, déjà décrite, la variation relative de la fréquence d'un pilote thermostaté classique, contenu dans un boîtier de protection étanche, en fonction du temps, lorsque la température extérieure au pilote varie ;
- la figure 3, une coupe transversale d'un pilote thermostaté selon l'invention;
- la figure 4, une coupe transversale, d'une variante de l'enceinte thermostatée d'un pilote selon l'invention;
- la figure 5, une coupe transversale, d'une seconde variante de l'enceinte thermostatée d'un pilote selon l'invention;
- la figure 6, une coupe transversale, d'une troisième variante de l'enceinte thermostatée d'un pilote selon l'invention;
- la figure 7, la variation relative de la fréquence d'un pilote thermostaté conforme à l'invention, en fonction du temps, lorsque la température extérieure au pilote varie.

Sur ces figures, les mêmesrepères désignent les mêmes éléments.

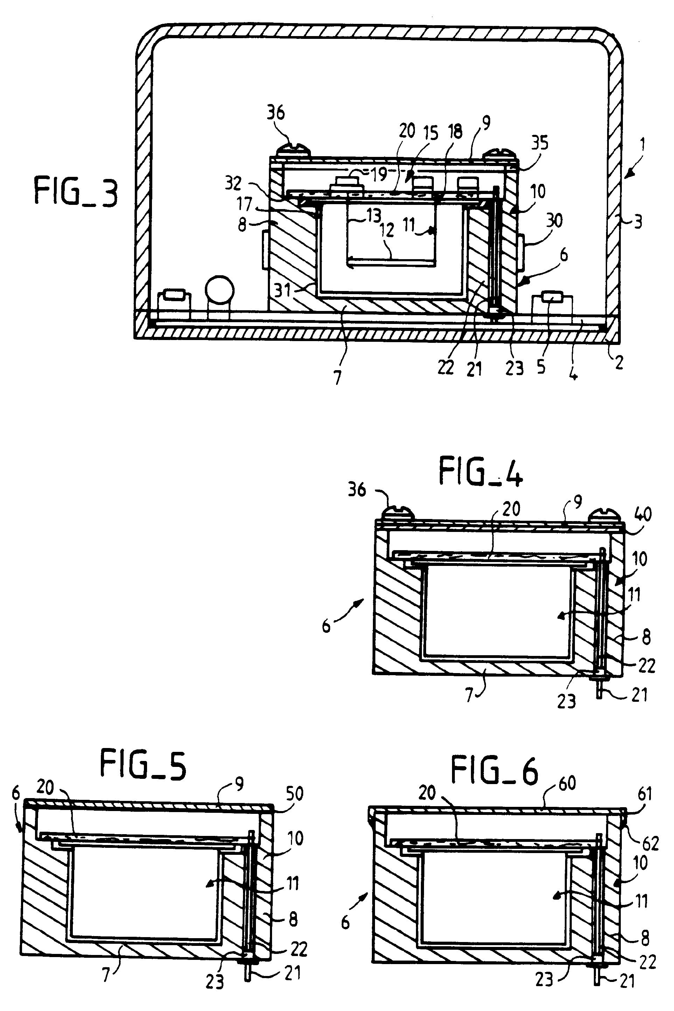

La figure 3 représente une coupe transversale d'un pilote thermostaté conforme à l'invention. Ce pilote est contenu dans un boîtier de protection 1 comportant une embase 2 surmontée d'un capot 3. Ce boîtier de protection 1 peut être fermé de façon étanche ou au contraire de façon perméable. La fermeture du boîtier n'a pas d'influence sur la dérive en fréquence du pilote. A l'intérieur du boîtier de protection 1, on a monté sur une plaquette 4 du circuit imprimé, une enceinte 6 thermostatée et des composants électroniques 5 pour réaliser, par exemple, un amplificateur de sortie, un circuit de régulation de tension, un circuit de régulation de température. L'enceinte thermostatée 6 comprend un corps 10 et un couvercle 9. Le corps 10 est constitué d'un fond 7 et de côtés 8. Cette enceinte thermostatée 6 est réalisée, de préférence, dans un métal bon conducteur de la chaleur.

A la surface extérieure du corps 10 de l'enceinte 6, on a placé des éléments de chauffage 30. Ces éléments de chauffage sont, par exemple, des transistors de puissance.

A l'intérieur de l'enceinte thermostatée 6, on a introduit un résonateur piézoélectrique 11. Ce résonateur 11 comprend une lame 12 en matériau piézoélectrique maintenue par deux poteaux 13 électriquement conducteurs. Ils assurent directement ou non la liaison électrique avec un oscillateur 15 situé aussi à l'intérieur de l'enceinte thermostatée.

La lame piézoélectrique 12 est encapsulée dans un boîtier constitué d'un capot 17 et d'une embase 18. Le capot 17 et l'embase 18 sont réunis de façon étanche et l'intérieur est soumis soit au vide, soit à une pression basse d'un gaz tel que l'azote, par exemple.

Le corps 10 de l'enceinte thermostatée 6 comprend un alésage 31 formant une cavité destinée à recevoir le boîtier du résonateur 11. L'alésage 31 a des dimensions choisies pour que le boîtier du résonateur 11 soit en contact thermique avec le corps 10 de l'enceinte thermostatée 6.

La lame 12 peut être réalisée en quartz ou dans un autre matériau piézoélectrique, le tantalate de lithium, par exemple.

L'oscillateur 15 est réalisé par un circuit électronique 19 monté sur une plaquette 20 de circuit imprimé, par exemple. On a représenté la plaquette 20 de circuit imprimé qui repose sur un embrèvement 32 porté par le corps 10 de l'enceinte thermostatée 6. La plaquette 20 est située entre le résonateur 11 et le couvercle 9 de l'enceinte thermostatée 6.

Des fils électriques 21 assurent la liaison électrique entre l'oscillateur 15 et les composants électroniques 5 placés à l'extérieur de l'enceinte thermostatée 6. Ces fils 21 passent dans un conduit 22 creusé dans l'épaisseur d'un côté 8 du corps 10 de l'enceinte 6.

Selon l'invention, on prévoit que l'enceinte 6 thermostatée est étanche. Pour cela on dispose un cordon continu de pâte à joint 35, sur le bord du corps 10 de l'enceinte thermostatée, avant d'appliquer le couvercle 9. Le couvercle 9 a la forme d'une plaque. On fixe de façon classique, le couvercle 9 sur le corps 10 par au moins deux vis 36, par exemple.

En vissant le couvercle 9 sur le corps 10, on écrase le cordon de pâte à joint 35 et ce dernier assure l'étanchéité de l'enceinte thermostatée. Les vis 36 assurent elles un maintien mécanique entre le corps 10 de l'enceinte 6 et le couvercle 9.

A leur sortie de l'enceinte 6, les fils 21 traversent un bouchon étanche 23 fixé, par brasage ou collage, par exemple, sur le corps 10 de l'enceinte thermostatée 6.

L'invention prévoit, en outre, que le corps 10 et le couvercle 9 de l'enceinte 6 thermostatée sont suffisament rigides pour supporter, sensiblement sans déformation, les différences de pression pouvant exister entre l'intérieur et l'extérieur de l'enceinte thermostatée 6. En effet, au moment de la fixation du couvercle 9, une même pression règne à l'intérieur et à l'extérieur de l'enceinte thermostatée 6. Mais le pilote thermostaté peut être utilisé dans une application spatiale et dans ce cas, il pourra être confronté à des pressions externes extrêmement faibles.

Les figures 4,5,6 représentent des variantes pour réaliser l'étanchéité de l'enceinte thermostatée 6. Seule l'enceinte est représentée et l'on n'a pas dessiné ni les composants électroniques, ni la lame de quartz, ni les poteaux conducteurs.

Sur la figure 4, on a utilisé un joint 40 pour réaliser l'étanchéité de l'enceinte thermostatée 6. Ce joint 40 repose sur le bord du corps 10. Comme précédemment, lorsque l'on visse le couvercle 9, le joint 40 est écrasé. Le joint 40 représenté est un joint plat.

On aurait pu envisager d'employer un joint torique. Ce joint aurait pu être encastré, partiellement, dans une rainure creusée dans le corps de l'enceinte tout le long de sa périphérie. Cette variante n'est pas représentée.

La figure 5 représente une autre variante de l'enceinte thermostatée. Maintenant on a collé le couvercle 9 sur le corps 10 de l'enceinte thermostatée 6. Pour cela, avant d'appliquer le couvercle 9 on a déposé un filet de colle 50 tout le long du bord du corps 10 de l'enceinte 6. On choisit une colle résistant à l'humidité et à la chaleur. On n'a plus besoin de vis, la colle assure à la fois l'étanchéité de l'enceinte thermostatée 6 et le maintien mécanique entre le couvercle 9 et le corps 10 de l'enceinte thermostatée 6. Cette solution est un peu délicate à mettre en oeuvre et le couvercle est pratiquement indémontable.

La figure 6 représente encore une variante pour monter de façon étanche le couvercle 60 sur le corps 10 de l'enceinte thermostatée 6. Maintenant le couvercle 60 comporte un rebord 61. Lorsque le couvercle 60 est en place, son rebord 61 est en contact avec la surface extérieure du corps 10 de l'enceinte thermostatée 6. On peut alors braser, à l'indium plomb, par exemple, le couvercle 60 le long du corps 10. On a représenté un congé 62 de brasure en contact à la fois avec le couvercle 60 et le corps 10. Dans cette configuration, la brasure assure à la fois l'étanchéité de l'enceinte thermostatée et le maintient mécanique entre le corps 10 et le couvercle 60.

Le fait de rendre l'enceinte étanche permet de maintenir à l'intérieur de l'enceinte un taux d'humidité et une pression constants, quelles que soient les conditions climatiques extérieures au pilote. Le boîtier de protection du pilote n'a plus d'influence sur la variation relative de la fréquence. Il peut être étanche ou perméable.

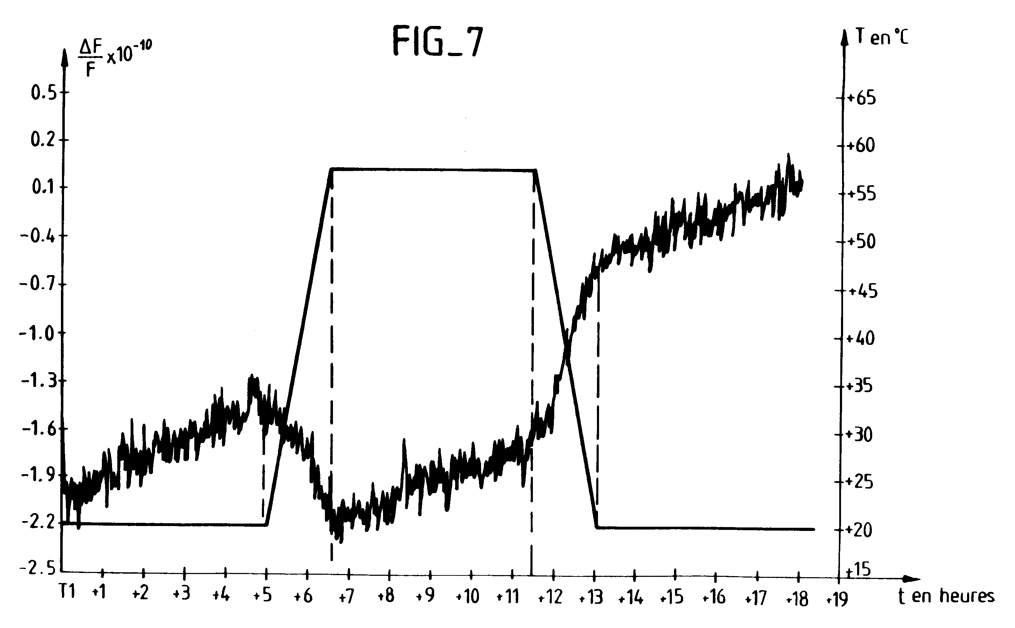

La figure 7 représente la variation relative de la fréquence du pilote thermostaté selon l'invention, en fonction du temps, lorsque la température extérieure varie par paliers. Le pilote est contenu dans un boîtier de protection étanche mais ce boîtier n'a pas d'influence sur la fréquence et il aurait pu être non étanche.

La variation de la température est la suivante :
- entre le temps T1 et T1+5 h la température est constante et égale à +20° C;
- entre le temps T1+5 h et T1+6h30 la température croît linéairement de +20° C à +57° C,
- entre le temps T1+6h30 et T1+11h30 la température est constante et égale à +57° C;
- entre le temps T1+11h30 et T1+13h, la température décroît linéairement de +57° C à +20° C;
- entre le temps T1+13h et T1+18h, la température est constante et égale à +20° C.

Pendant les trois paliers de température, la courbe de la fréquence est sensiblement linéaire avec une pente faible. La pente est sensiblement la même sur les trois tronçons.

Cette pente est liée au vieillissement du résonateur dans les premiers temps de son fonctionnement. C'est un phénomène normal.

Il n'y a pas d'autre dérive en fréquence pendant les paliers de température, les trois tronçons de courbe sont sensiblement parallèles.

La variation de la fréquence relevée se produit pendant les fronts de montée et descente en température. Elle est due aux imperfections du thermostat et des composants électroniques. Cette variation de fréquence est faible, elle est de l'ordre de $6.10^{-11}$ pour une variation de température de 37°C. Cette variation est très inférieure à celles observées sur les courbes des figures 1 et 2.

Les mesures montrent qu'en utilisant une enceinte thermostatée classique, la sensibilité en barométrie du pilote était de l'ordre de $1.10^{-8}$/bar. Lorsque l'on rend étanche l'enceinte, la sensibilité en barométrie du pilote passe à $5.10^{-10}$/bar. Le gain en barométrie est de l'ordre de 20. Il n'est alors plus nécessaire de monter dans le pilote, un résonateur à hautes performances en barométrie. Un résonateur à performances moyennes peut être utilisé et le coût du pilote est alors abaissé.

L'invention n'est pas limitée aux exemples décrits notamment l'enceinte thermostatée peut être rendue étanche par tout autre moyen.

## Revendications

1. Pilote thermostaté comportant un résonateur (11) piézoélectrique inséré dans une enceinte thermostatée (6) comprenant un corps (10) et un couvercle (9), le résonateur (11) comprenant un boitier étanche, caractérisé en ce qu'en vue de réduire la dérive en fréquence du pilote en fonction de variations climatiques, l'enceinte thermostatée (6) est étanche et en ce que le corps (10) et le couvercle (9) de l'enceinte (6) sont suffisament rigides pour supporter sensiblement sans déformation les différences de pression pouvant exister entre l'intérieur et l'extérieur de l'enceinte thermostatée (6).

2. Pilote thermostaté selon la revendication 1 caractérisé en ce que de la pâte à joint (35) assure l'étanchéité entre le couvercle (9) et le corps (10) de l'enceinte thermostatée (6), des moyens mécaniques (36) permettant de fixer le couvercle (9) sur le corps (10).

3. Pilote thermostaté selon la revendication 1 caractérisé en ce qu'un joint (40) assure l'étanchéité entre le couvercle (9) et le corps (10) de l'enceinte thermostaté (6), des moyens mécaniques (36) permettant de fixer le couvercle (9) sur le corps (10).

4. Pilote thermostaté selon l'une des revendications 2 ou 3 caractérisé en ce que les moyens mécaniques (36) sont réalisés par au moins deux vis passant à travers le couvercle (9) et se vissant dans l'épaisseur du corps (10) de l'enceinte thermostatée (6).

5. Pilote thermostaté selon la revendication 1 caractérisé en ce que de la colle (50) assure l'étanchéité et le maintient mécanique entre le couvercle (9) et le corps (10) de l'enceinte thermostatée (6).

6. Pilote thermostaté selon la revendication 5 caractérisé en ce que la colle résiste à l'humidité et à la chaleur .

7. Pilote thermostaté selon la revendication 1 caractérisé en ce que le couvercle (60) est brasé sur le corps (10) de l'enceinte thermostatée (6), la brasure assurant l'étanchéité et le maintient mécanique entre le couvercle (60) et le corps (10) de l'enceinte thermostatée (6).

8. Pilote thermostaté selon l'une des revendications 1 à 7, des fils électriques (21) assurant la liaison électrique entre l'intérieur et l'extérieur de l'enceinte thermostatée (6), caractérisé en ce que ces fils (21) traversent un bouchon étanche (23) fixé sur le corps (10) de l'enceinte thermostatée (6).

9. Pilote thermostaté selon l'une des revendications 1 à 8 caractérisé en ce qu'il est contenu dans un boîtier de protection (1).

## Patentansprüche

1. Thermostatisch geregelter Pilotschwinger mit einem piezoelektrischen Resonator (11), der in einen einen Körper (10) und einen Deckel (9) enthaltenden thermostatisch geregelten Behälter (6) eingesetzt ist, wobei der Resonator (11) seinerseits ein dichtes Gehäuse aufweist, dadurch gekennzeichnet, daß zur Verringerung der Frequenzabweichung des Pilotschwingers abhängig von Klimaänderungen der thermostatisch geregelte Behälter (6) dicht ausgebildet ist und daß der Körper (10) und der Deckel (9) des Behälters (6) ausreichend steif sind, um im wesentlichen ohne Verformungen den Druckunterschieden zu widerstehen, die zwischen dem Innenraum des thermostatisch geregelten Behälters (6) und der Außenseite auftreten können.

2. Thermostatisch geregelter Pilotschwinger nach Anspruch 1, dadurch gekennzeichnet, daß eine Dichtmasse (35) die Dichtheit zwischen dem Deckel (9) und dem Körper (10) des thermostatisch geregelten Behälters (6) gewährleistet und daß mechanische Mittel (36) zur Befestigung des Deckels (9) auf dem Körper (10) vorgesehen sind.

3. Thermostatisch geregelter Pilotschwinger nach Anspruch 1, dadurch gekennzeichnet, daß eine Dichtung (40) die Dichtheit zwischen dem Deckel (9) und dem Körper (10) des thermostatisch geregelten Behälters (6) gewährleistet und daß der Deckel (9) durch mechanische Mittel (36) auf dem Körper (10) befestigt ist.

4. Thermostatisch geregelter Pilotschwinger nach einem der Ansprüche 2 oder 3, dadurch gekennzeichnet, daß die mechanischen Mittel (36) aus mindestens zwei Schrauben bestehen, die durch den Deckel (9) verlaufen und in die Wand des Körpers (10) des thermostatisch geregelten Behälters (6) eindringen.

5. Thermostatisch geregelter Pilotschwinger nach Anspruch 1, dadurch gekennzeichnet, daß ein Kleber (50) die Dichtheit und den mechanischen Halt zwischen dem Deckel (9) und dem Körper (10) des thermostatisch geregelten Behälters (6) gewährleistet.

6. Thermostatisch geregelter Pilotschwinger nach Anspruch 5, dadurch gekennzeichnet, daß der Kleber gegen Feuchtigkeit und Wärme beständig ist.

7. Thermostatisch geregelter Pilotschwinger nach Anspruch 1, dadurch gekennzeichnet, daß der Deckel (60) auf den Körper (10) des thermostatisch geregelten Behälters (6) aufgelötet ist, wobei die Lötspur die Dichtheit und den mechanischen Halt zwischen dem Deckel (60) und dem Körper (10) des thermostatisch geregelten Behälters (6) gewährleistet.

8. Thermostatisch geregelter Pilotschwinger nach einem der Ansprüche 1 bis 7, bei dem elektrische Drähte (21) die elektrische Verbindung zwischen dem Innenraum und der Außenseite des thermostatisch geregelten Behälters (6) gewährleisten, dadurch gekennzeichnet, daß diese Drähte (21) einen Dichtstopfen (23) durchqueren, der auf dem Körper (10) des thermostatisch geregelten Behälters (6) befestigt ist.

9. Thermostatisch geregelter Pilotschwinger nach einem der Ansprüche 1 bis 8, dadurch gekennzeichnet, daß er von einem Schutzgehäuse (1) umgeben ist.

## Claims

1. Thermostatted master-control device which includes a piezoelectric resonator (11) inserted into a thermostatted enclosure (6) comprising a body (10) and a lid (9), the resonator (11) comprising a sealed case, characterized in that, for the purpose of reducing the frequency drift of the master-control device as a function of environmental variations, the thermostatted enclosure (6) is sealed and in that the body (10) and the lid (9) of the enclosure (6) are sufficiently rigid to support, substantially without deformation, the pressure differences which may exist between the inside and the outside of the thermostatted enclosure (6).

2. Thermostatted master-control device according to Claim 1, characterized in that the sealant (35) provides sealing between the lid (9) and the body (10) of the thermostatted enclosure (6), mechanical means (36) enabling the lid (9) to be fixed to the body (10).

3. Thermostatted master-control device according to Claim 1, characterized in that a seal (40) provides sealing between the lid (9) and the body (10) of the thermostatted enclosure (6), mechanical means (36) enabling the lid (9) to be fixed to the body (10).

4. Thermostatted master-control device according to one of Claims 2 and 3, characterized in that the mechanical means (36) are provided by at least two screws which pass right through the lid (9) and are screwed into the thickness of the body (10) of the thermostatted enclosure (6).

5. Thermostatted master-control device according to Claim 1, characterized in that adhesive (50) provides sealing and mechanical retention between the lid (9) and the body (10) of the thermostatted enclosure (6).

6. Thermostatted master-control device according to Claim 5, characterized in that the adhesive is moisture-resistant and heat-resistant.

7. Thermostatted master-control device according to Claim 1, characterized in that the lid (60) is brazed to the body (10) of the thermostatted enclosure (6), the braze providing sealing and mechanical retention between the lid (60) and the body (10) of the thermostatted enclosure (6).

8. Thermostatted master-control device according to one of Claims 1 to 7, electrical leads (21) providing electrical connection between the inside and the outside of the thermostatted enclosure (6), characterized in that these leads (21) pass through a sealed plug (23) fixed to the body (10) of the thermostatted enclosure (6).

9. Thermostatted master-control device according to one of Claims 1 to 8, characterized in that it is contained in a protective case (1).

FIG_1

$\frac{\Delta F}{F} \cdot 10^{-10}$

T en °C

t en heures

EP 0 449 721 B1

FIG_2

FIG_3

FIG_4

FIG_5

FIG_6

FIG_7